# EUROPEAN PATENT SPECIFICATION

(11) **EP 4 503 035 B1**
(45) Date of publication and mention of the grant of the patent: **22.04.2026**
(21) Application number: 23189157.3
(22) Date of filing: 02.08.2023
(51) Int. Cl.: G11C 19/28

(54) **A 3D INTEGRATED CHARGE COUPLED DEVICE MEMORY**
INTEGRIERTER 3D-LADUNGSTRANSFERSPEICHER
MÉMOIRE À DISPOSITIF À COUPLAGE DE CHARGE INTÉGRÉ 3D

(43) Date of publication of application: 05.02.2025
(73) Proprietor: Imec VZW, 3001 Leuven (BE)
(72) Inventor: Mahato, Swaraj Bandhu, 3012 Wilsele (BE); Rosmeulen, Maarten, 9000 Gent (BE)
(74) Representative: Roth, Sebastian

(56) References cited:
- US-A- 3 858 232
- US-A- 5 077 762

## Description

### TECHNICAL FIELD

The present disclosure relates to a charge-coupled device (CCD) memory. In particular, the disclosure provides an architecture and operation for a three-dimensional (3D) integrated CCD-based block-addressable storage class memory.

### BACKGROUND

Today, data creation is skyrocketing, propelled by data-driven technologies. This has left the memory (or storage) pyramid in urgent need of transformation. In particular, the gap between low-cost storage memory and high-speed working memory has to be bridged. The gap results from a mismatch between the increasing need for computing growing amounts of data versus trends in the underlying memory technologies. The increasing demand and the approaching scaling "brick wall" of conventional dynamic random access memory (DRAM) has prompted the search for new types of memory.

For instance, various types of so-called storage class memory (SCM) have been proposed, but no completely satisfactory solution has emerged yet. The available alternatives for DRAM lack either scalability like phase change memory (PCM), or lack power efficiency like magnetic random access memory (MRAM), or lack cycling capability like low-latency NAND memory.

CCD-based block addressable SCM has emerged as a fundamentally new class of memory, and is considered a good candidate for bridging the memory gap, while having a significant cost advantage over DRAM. The CCDs lack the byte-addressability, which is conventionally required for RAM. One idea employed in this disclosure is to trade this byte-addressability for lower costs. However, a CCD-based memory array architecture is needed - along with efficient read, write, and refresh schemes - to realize the high memory cell densities desired.

US 3858232 A discloses information storage devices.

US 5077762 A discloses a charge transfer device having Metal-Insulator-Metal (MIM) structures and a method for driving the same.

### SUMMARY

In view of the above, this disclosure aims to provide an improved SCM based on a CCD. An objective thereby is to provide a memory array architecture, which enables high memory cell densities. Another objective thereby is to provide a block-addressable SCM. Another objective is to provide, in particular, a write scheme for such a CCD-based SCM.

These and other objectives are achieved by the solutions of this disclosure as provided in the independent claims. Advantageous implementations are described in the dependent claims.

The solutions of this disclosure are based on an integrated 3D memory array architecture, which - along with at least a corresponding write scheme - allows realizing a SCM with high memory cell density.

A first aspect of this disclosure provides an integrated 3D CCD memory comprising: a layer stack including a plurality of gate layers and spacer layers, which are alternatingly arranged one on the other along a first direction; a plurality of semiconductor-based channels extending in the stack, wherein the channels form, in combination with the gate layers and one or more dielectric layers, a plurality of strings of charge storage capacitors operable as a plurality of CCD registers, wherein each of the one or more dielectric layers is arranged between one of the plurality of semiconductor-based channels and at least one of the plurality of gate layers; a plurality of blocks, wherein each block comprises a plurality of sub-blocks, and wherein each sub-block comprises a set of the CCD registers; wherein each block and each sub-block of the block is individually selectable, in order to write information into at least one CCD register of the sub-block of the block.

The charge storage capacitors may be connected in series to form the CCD registers. The charge storage capacitors may be MOS capacitors. The one or number of storage capacitors in the CCD register may be considered a memory cell of the CCD memory.

By integrating the CCD registers in a 3D arrangement - i.e., by building the stack of the gate layers and the spacer layers along the first direction, and by forming the channels in this stack, preferably aligned vertically along the first direction - a high density like in 3D NAND Flash can be achieved. Thus, the costs (per stored bit) may become low. The CCD memory of the first aspect can be used as SCM, under the premise that byte-addressability can be omitted. The CCD memory may provide high speeds, good reliability, nearly unlimited cycling, and low power consumption.

Moreover, the CCD memory of the first aspect is block-addressable, and even sub-block-addressable, which is beneficial for performance, endurance, and energy efficiency of the memory. Also the storage density can be increased.

In an implementation, the 3D CCD memory further comprises a plurality of input transfer-gates, wherein each sub-block is associated with at least one input-transfer gate, and the at least one input transfer-gate is configured to select the sub-block.

In an implementation of the 3D CCD memory, the plurality of input transfer-gates comprises a first set of input transfer-gates, which are associated with the sub-blocks of a first block, and a second set of input-transfer gates, which are associated with the sub-blocks of a second block.

The input transfer-gate enable a controlled access of the memory, and are beneficial as they may isolate different sub-blocks of the memory. Thus, they may lead to a reduced power consumption of the memory.

In an implementation of the 3D CCD memory, the input transfer-gates are defined in the topmost one or more gate layers of the layer stack, and wherein the topmost one or more gate layers are respectively separated into a plurality of parts, wherein each part is associated with one sub-block.

That is, the input transfer-gate-layers of the layer stack are cut, in order to separate the layers into the plurality of parts.

In an implementation of the 3D CCD memory, each input transfer-gate is connected to a sub-block selector and driver circuit.

In an implementation, the 3D CCD memory further comprises: a plurality of bit lines, wherein each bit line is associated with one or more CCD registers in a block and/or with one CCD register in a sub-block; and wherein the at least one input transfer-gate associated with the sub-block is operable to allow charge to be provided from a bit line to the CCD register associated with that bit line.

In an implementation of the 3D CCD memory, the bit lines associated with a block are connected to respective input junctions.

The input junctions allow for an efficient charge transfer into the CCD registers.

In an implementation of the 3D CCD memory, the bit lines are further connected to a bit-line selector and driver circuit, which is configured to insert charge via the bit lines into the CCDs registers of the sub-block, it the at least one input-transfer gate associated with the sub-block is operated.

In an implementation, the 3D CCD memory further comprises a plurality of word lines, wherein the CCD registers in one block are connected to the same set of word lines, and the word lines are operable to allow charge to be transported along the CCD registers.

The word lines may also be referred to as phase lines, and may be used to implement clocking. That is, the word lines may be used to coordinate the operation of a CCD register using a series of clocking phases, often referred to as PH1, PH2, etc. These clocking phases may be applied to different word lines, which may be used to control the potential barriers within the CCD register and thereby control the movement of charge along the CCD register.

A second aspect of this disclosure provides a method of operating a 3D CCD memory of the first aspect or any of its implementations, wherein for writing information into a CCD register of one sub-block the method comprises: individually selecting a block and a sub-block in the block; and inserting charge into the CCD-registers included in the selected sub-block.

In an implementation of the method, selecting the sub-block comprises activating the at least one input-transfer gate, which is associated with the sub-block.

In an implementation of the method, inserting the charge into the CCD registers comprises changing a voltage on the input junction, to which the bit lines associated with the selected block are connected.

In an implementation of the method, the charge is inserted into the CCD registers of each block and is then moved simultaneously along the CCD registers by operating clocking phases associated with the charge storage capacitors in the CCD registers.

The clocking phases may be operated by using and subsequently activating word lines that are associated with the clocking phases.

The method of the second aspect achieves the same advantages as the 3D CCD memory of the first aspect, and may be extended by respective implementations as described above for the 3D CCD memory of the first aspect.

### BRIEF DESCRIPTION OF THE DRAWINGS

The above described aspects and implementations are explained in the following description of embodiments with respect to the enclosed drawings:
- FIG. 1: shows an exemplary 3D CCD memory according to this disclosure with vertical CCD registers.
- FIG. 2: shows an architecture of an exemplary 3D CCD memory of this disclosure with multiple sub-blocks in a block.
- FIG. 3: shows a method according to this disclosure of operating a 3D CCD memory, for instance, as shown in FIG. 1 or FIG. 2.
- FIG. 4: shows a write scheme based on a "fill and spill" procedure, wherein one input transfer-gate is used.
- FIG. 5: shows a write scheme based on a "fill and spill" procedure, wherein two input transfer-gates are used.
- FIG. 6: shows a top view schematic of a CCD memory according to this disclosure, with CCD registers and bit-line contacts, and input transfer-gates represented as transistor symbols.
- FIG. 7: shows an array of an exemplary 3D CCD memory according to this disclosure with staggered CCD registers.
- FIG. 8: shows a block diagram of a memory block of a 3D CCD memory according to this disclosure.
- FIG. 9: shows a block diagram of a memory array of an exemplary 3D CCD memory of this disclosure comprising multiple memory blocks.

### DETAILED DESCRIPTION OF EMBODIMENTS

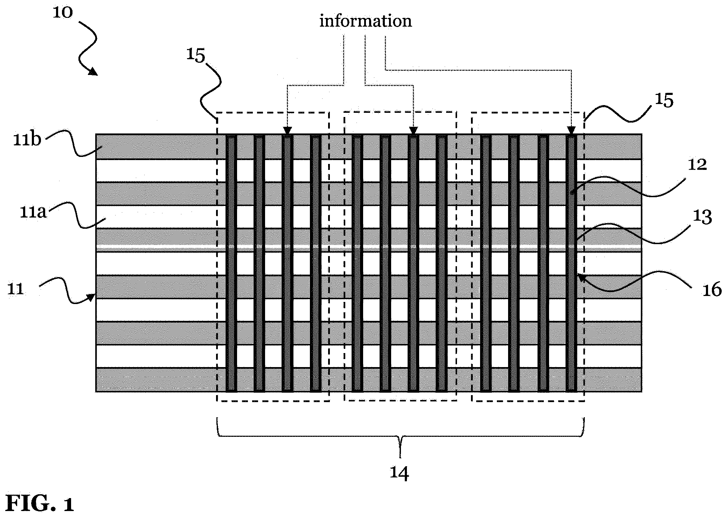

FIG. 1 shows an integrated 3D CCD memory 10 according to this disclosure. The CCD memory 10 can be a block-addressable SCM. The CCD memory 10 may be used as a DRAM replacement in some of its use cases, or as an improved substitute for various other types of SCM. For instance, the CCD memory 10 of this disclosure may provide better scalability than a PCM, and/or may have a better power efficiency than a MRAM, and/or may have a better cycling capability than low-latency NAND memory.

The CCD memory 10 comprises a layer stack 11, which includes a plurality of gate layers 11a and spacer layers 11b, which are alternatingly arranged one on the other along a first direction (which corresponds to the vertical direction in FIG. 1). The layer stack 11 may either start with a gate layer 11a or a spacer layer 11b (as bottommost layer), for instance, on a substrate. The layer stack 11 may likewise end with a gate layer 11a or a spacer layer 11b (as topmost layer), and the illustrated stack 11 of FIG. 1 is just an example.

The CCD memory 10 further comprises a plurality of semiconductor-based channels 12 extending in the stack 11. These channels 12 form, in combination with the gate layers 11a and with one or more dielectric layers 13, which may respectively extend parallel and adjacent to the channels, a plurality of strings of charge storage capacitors. Each of the one or more dielectric layers 13 is arranged between one of the plurality of semiconductor-based channels 12 and at least one of the plurality of gate layers 11a. These charge storage capacitors are operable as a plurality of CCD registers 16. Notably, each gate layer 11a may surround one or more of the semiconductor-based channels 12.

The semiconductor-based channels 12 may respectively be made of a semiconductor oxide material. For instance, the semiconductor oxide material may comprise at least one of indium gallium zinc oxide (IGZO), indium tin oxide (ITO), and indium zinc oxide (IZO), or another wide-bandgap oxide semiconductor. Such wide-bandgap oxide semiconductors allow achieving an increased retention time of the CCD memory 10. The semiconductor-based channels 12 may also be made of a silicon-based semiconductor material or of a III-V semiconductor material.

In order to fabricate the plurality of channels 12, a plurality of holes may formed through the entire layer stack 11, and may then be plugged with the semiconductor-based material, for example, with the semiconductor oxide material like IGZO, along with one or a plurality of the dielectric layers 13, wherein the dielectric layers 13 each are arranged between one of the semiconductor-based channels and at least one of the gate layers 11a. Thereby, the strings of charge storage capacitors connected together as a CCD register architecture are formed.

The semiconductor-based channels 12 may extend along the first direction and/or may extend perpendicular to the parallel surfaces of the gate layers 11a. The semiconductor-based channels 12 may be straight in the stack 11, or may have a bend in the stack 11, in particular, they could respectively have a U-shape. The semiconductor-based channels 12 may be full channels or macaroni-type channel.

The CCD memory 10 further comprises a plurality of blocks 14, e.g., Memory Block (MB). Each block 14 comprises a plurality of sub-blocks 15. Each sub-block 15 comprises a set of one or more of the CCD registers 16. That means, each block 14 comprises a plurality of the CCD registers 16. The CCD memory 10 is block-addressable, particularly, even sub-block addressable. That is, each block 14 of the memory 10, and each sub-block 15 of the block, is individually selectable (or addressable), for instance, to write information (represented by charge) into at least one CCD register 16 of the sub-block 15 of the block 14.

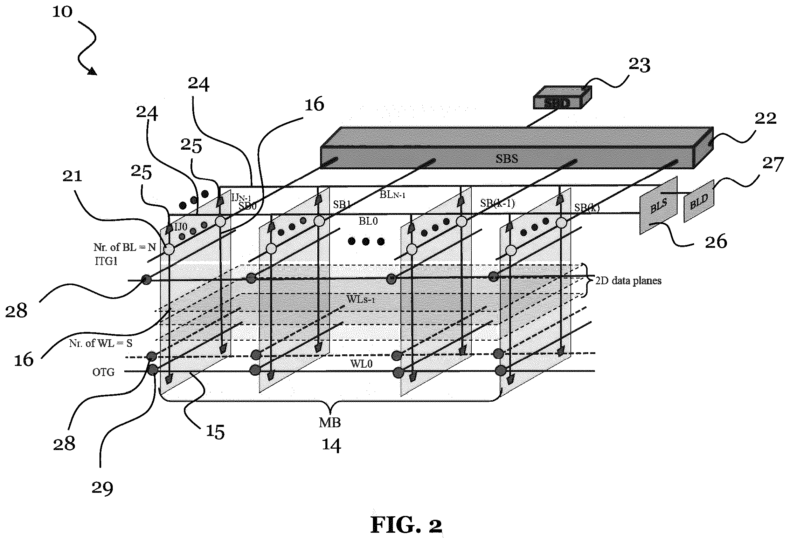

FIG. 2 shows an architecture of an exemplary 3D CCD memory 10 of this disclosure, which builds on the CCD memory 10 shown in FIG. 1. Accordingly, the architecture shown in FIG. 2 is also based on the 3D approach of the vertical CCD registers 16 with the horizontal gate layers 11a, as illustrated in FIG. 1 (where horizontal and vertical may denote two perpendicular directions).

The CCD memory 10 also comprises a plurality of bit lines 24. Each bit line 24 is associated with one or more CCD registers 16 in a block 14 and/or is associated with one CCD register 16 in a sub-block 15. The CCD memory 10 further comprises a plurality of word lines 28, which may extend in the horizontal direction, as shown in FIG. 2, or generally along a second direction, which is perpendicular to the first direction. The CCD registers 16 in one block 14 of the memory 10 are connected to the same set of word lines 28. These word lines 28 of the set are operable to allow charge to be transported along the CCD registers 16, for example, by using the word lines 28 to operate clocking phases associated with the charge storage capacitors in the CCD registers 16.

Each CCD register 16 may comprises one or more output transfer-gates 29, which are defined in the one or more gate layers 11a that are closest to an output end of the CCD register 16. That is, the bottommost gate layers 11a in FIG. 1 may define the output transfer-gates 29 of the CCD register 16. The one or more output transfer-gates 29 may be controlled (e.g., by a subset of word lines 28) to allow charge to move from the string of charge storage capacitors of the CCD register 16 to an output of the CCD register 16, e.g., into a floating diffusion formed at the output end of the CCD register 16.

The CCD memory 10 further comprises a plurality of input transfer-gates 21, which are indicated at the top of the structure in FIG. 2. Each sub-block 15 of the CCD memory 10 may be associated with at least one input-transfer gate 21, and this at least one input transfer-gate 21 is configured to select the sub-block 15. The input transfer-gates 21 shown in FIG. 2 may to this end be connected to a sub-block selector 22 and driver circuit 23. The input transfer-gates 21 may be defined in the one or more gate layers 11a that are closest to an input end of the CCD register 16. That is, the topmost gate layers 11a in FIG. 1 may define the input transfer-gates 21 of the CCD register 16. The one or more input transfer-gates 21 may be controlled e.g., by a subset of word lines 28.

The bit lines 24 can be connected to respective input junctions 25. The bit lines 24 may be further connected to a bit-line selector 26 and driver circuit 27, which are respectively configured to insert charge via the bit lines 24 into the CCDs registers 16 of the sub-block 15, if the at least one input-transfer gate 21, which is associated with the sub-block 15, is operated.

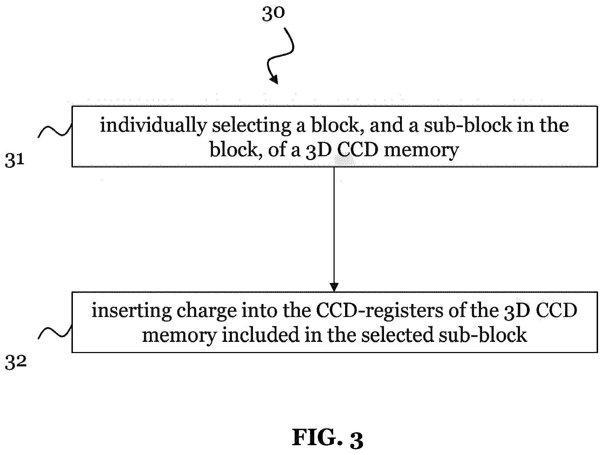

Generally, in order to write information into a CCD register 16 of one sub-block 15, for instance, in the memory architecture shown in FIG. 2, a method 30 as shown in FIG. 3 may be performed. The method 30 comprises a step 31 of individually selecting a block 14 and a sub-block 15 in the block 14. That is, each sub-block 15 is individually addressable. The method 30 further comprises a step 32 of inserting charge into the CCD-registers 16 included in the selected sub-block 15.

In particular, in the 3D CCD memory architecture shown in FIG. 2, a variant of a "fill and-spill" procedure may be used to inject 32 the charge into at least one CCD register 16. This process of injecting 32 charge may be referred to as bit writing. The input transfer-gates 21 may thereby function to select a set of CCD registers 16 to do the write operation on them.

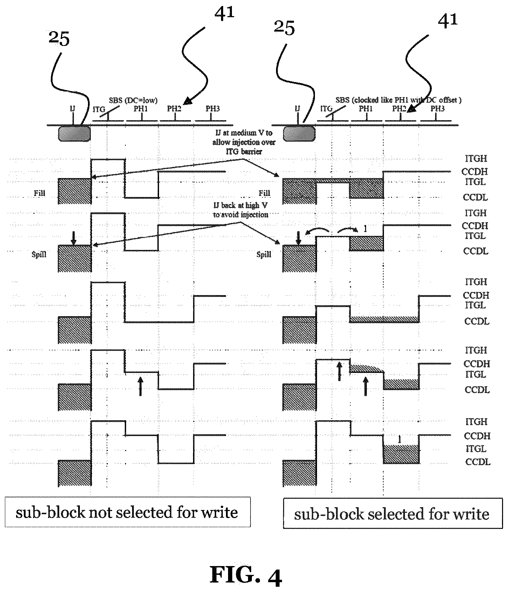

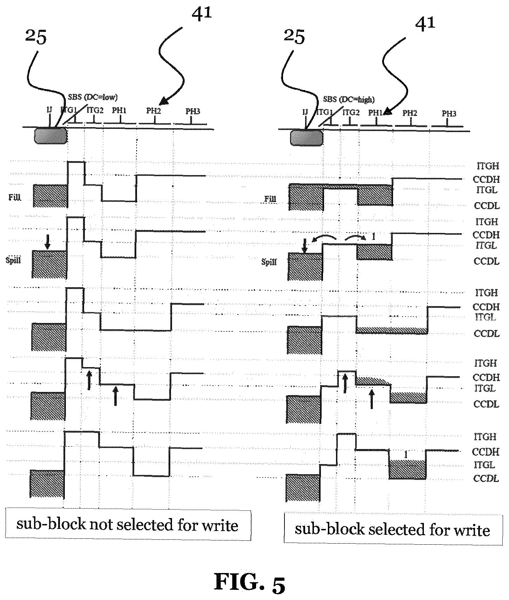

FIG. 4 and FIG. 5 depict this bit writing scheme with one input-transfer gate 21 and with two input transfer-gates 21, respectively. In FIGs. 4 and 5, the left side shows a sub-block 15 that is not selected for the write during the bit writing, and the right side shows the sub-block 15 that is selected for the write during the bit writing.

As shown in FIG. 4 and 5, the activation of at least one input-transfer gate 21, which is associated with the sub-block 15, results in the selection or addressing of that sub-block 15. In particular, the input transfer-gate 21 is shown to be activated in the right side of FIG. 4 and 5, respectively, with the result of lowering a potential barrier and consequently allowing the injection of charge into the CCD register 16. At the same time, the input junction 25 (IJ) may be adjusted from a high voltage to a medium voltage, i.e., the voltage of the input junction 25 may be lowered, in order to facilitate the injection of the charge. The injection of the charge fills the first charge storage capacitor of the CCD register. Subsequently, the input junction 25 can be returned to the initial high voltage again. In essence, the process of inserting 32 charge into the CCD registers 16 involves a voltage modification at the input junction 25, the latter being connected to the bit lines 24 that are associated with the chosen block 14.

Once the charge is inserted 32 into the CCD registers 16 of each block 14, the charge may be moved in unison along the CCD registers 16. This movement may be facilitated by operating clocking phases 41 (PH1, PH2, PH3), which are associated with the charge storage capacitors in the CCD registers 16 and may be controlled by a set of word lines 28.

The above may implement the spill of the "fill and spill" procedure. The "fill and spill" denotes a two-step process, wherein the injection cycle starts when the input junction potential is set above the minimum of the channel potential under the input transfer-gate 21 and potential wells under both input transfer-gate 21 and the first gate (e.g. first storage capacitor) of the CCD register 16 which is kept open during this period ("Fill" phase in FIG. 4)-. Then the input junction potential is increased to a higher level (deeper potential well), and then the charge above the input transfer-gate depletion potential "spills" back into the input junction 25. The difference between the channel potentials under the input transfer-gate 21 and the first gate (e.g. first storage capacitor) of the CCD register 16 determines the amount of charge injected into the CCD register 16.

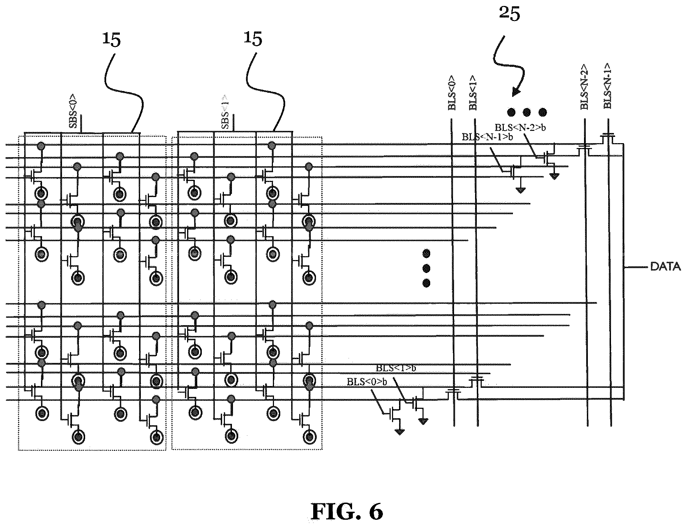

FIG. 6 shows a top view of a schematic of a CCD memory 10 according to this disclosure, in particular, shows CCD registers 16 and bit-line contacts, and also input transfer-gates 21 that are represented by transistor symbols. Although the input transfer-gates 21 may be defined in the one or more top gate layers 11a in the CCD register structure, in FIG. 6 they are presented as separate control gate schematics, which are connected to the CCD registers 16, for a better visualization and understanding.

The CCD registers 16 can be arranged in a staggered configuration along the direction of the word lines 28, which offers the potential to reduce the array size in one direction. This staggered arrangement of CCD registers 16 implies the construction of a page using two rows of CCD registers 16. While this configuration results in an enhanced bit line density, it also provides a notable saving in terms of area.

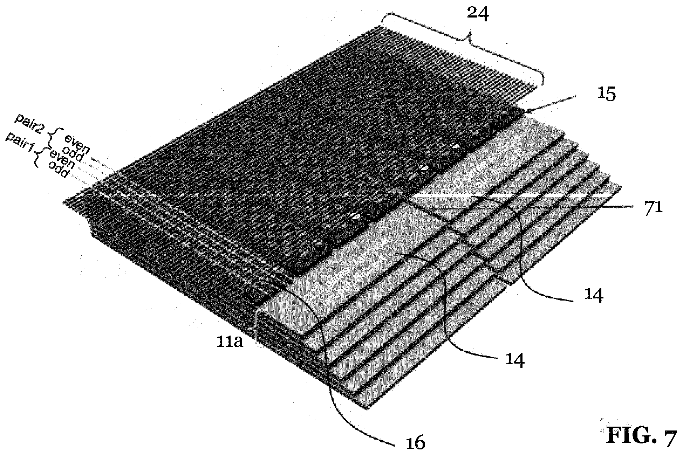

This architecture can be further optimized by implementing staggered bit line contacts. FIG. 7 illustrates an array of a 3D CCD memory 10 of this disclosure, which employs both staggered CCD registers 16 and staggered bit line contacts. In this design, a sub-block 15 is constructed using two pairs of rows of CCD registers 16, wherein each pair comprises an 'odd' and an 'even' rows. This arrangement further underscores the efficiency and space-saving benefits of a staggered configuration.

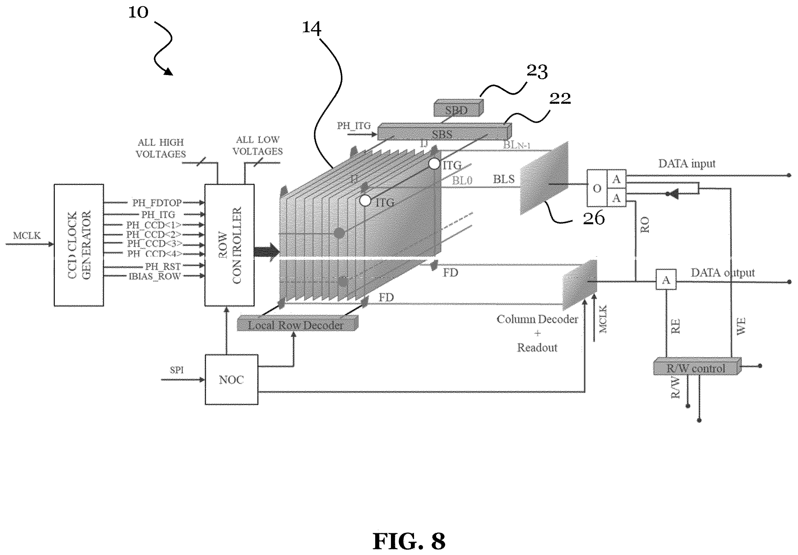

FIG. 8 illustrates a block diagram of an exemplary 3D CCD memory module 10, as outlined in this disclosure. More specifically, the diagram showcases a memory block 14 within the CCD memory 10. If a write operation into one or more CCD registers 16 is initiated-potentially by an internal logic of the CCD memory 10-the relevant information is transcribed as charge into the topmost charge storage capacitors of the string. This process can involve the sequential selection of sub-blocks 15 in a horizontal direction. Once a full 2D memory space at the top of the memory block 14 (i.e., the first stage of the CCD memory block 14) is written, the 2D data space shifts vertically downward, and fresh data can be inscribed at the top simultaneously.

During a read operation, local row and column decoders can be engaged to sequentially retrieve information (as voltage) via readout circuits. The memory 10 may feature a control logic mechanism to determine whether information bits are slated for reading or for rewriting and recirculating through the memory block 14 during a refresh cycle, depending on a control signal for read or refresh. Throughout a refresh cycle, old information could follow the same write path as new input information, and could be re-routed back to the first stage of the block 14. A separate logic circuit could control the insertion of a refresh cycle amidst a write operation.

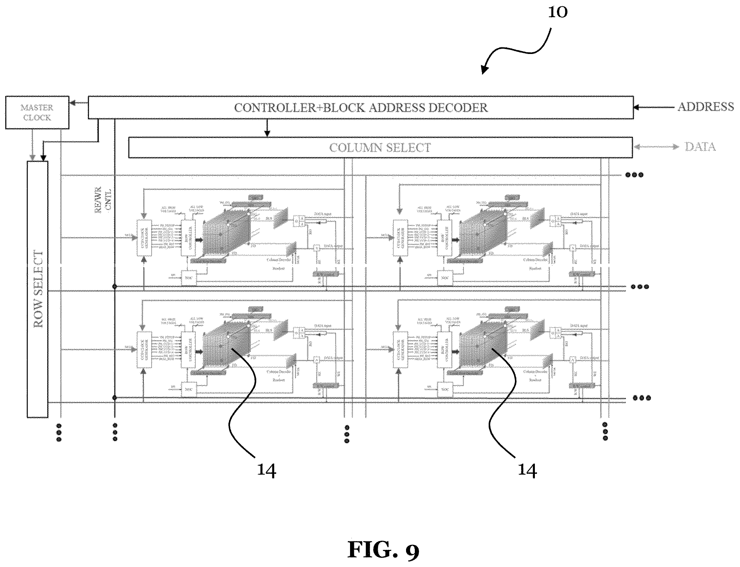

FIG. 9 shows a block diagram of a memory array of an exemplary 3D CCD memory 10 of this disclosure, wherein the memory 10 comprises multiple memory blocks 14. Each memory block 14 may be as shown in FIG. 8, and may be associated with a CCD clock generator and a row controller. Moreover, the memory 10 of may comprise a block address decoder, a row select circuit, and a column select circuit.

The multiple memory blocks of the memory 10 may be accessed randomly by the column select and the row select circuits according to decoded block addresses.

In summary, this disclosure provides an integrated 3D CCD-based block-addressable SCM 10, along with a write procedure, which allow realizing high memory densities and improved performance parameters compared to conventional SCM.

## Claims

1. An integrated three-dimensional, 3D, charge-coupled device, CCD, memory (10) comprising:
a layer stack (11) including a plurality of gate layers (11a) and spacer layers (11b), which are alternatingly arranged one on the other along a first direction;
a plurality of semiconductor-based channels (12) extending in the stack (11), wherein the channels (12) form, in combination with the gate layers (11a) and one or more dielectric layers (13), a plurality of strings of charge storage capacitors operable as a plurality of CCD registers (16), wherein each of the one or more dielectric layers (13) is arranged between one of the plurality of semiconductor-based channels (12) and at least one of the plurality of gate layers (11a);
a plurality of blocks (14), wherein each block (14) comprises a plurality of sub-blocks (15), and wherein each sub-block (15) comprises a set of the CCD registers (16);
wherein each block (14) and each sub-block (15) of the block (14) is individually selectable, in order to write information into at least one CCD register (16) of the sub-block (15) of the block (14).

2. The 3D CCD memory (10) of claim 1, further comprising a plurality of input transfer-gates (21), wherein each sub-block (15) is associated with at least one input-transfer gate (21), and the at least one input transfer-gate (21) is configured to select the sub-block (15).

3. The 3D CCD memory (10) of claim 2, wherein the plurality of input transfer-gates (21) comprises a first set of input transfer-gates (21), which are associated with the sub-blocks (15) of a first block (14), and a second set of input-transfer gates (21), which are associated with the sub-blocks (15) of a second block (14).

4. The 3D CCD memory (10) of claim 2 or 3, wherein the input transfer-gates (21) are defined in the topmost one or more gate layers (11a) of the layer stack (11), and wherein the topmost one or more gate layers (11a) are respectively separated into a plurality of parts, wherein each part is associated with one sub-block (15).

5. The 3D CCD memory (10) of one of the claims 2 to 4, wherein each input transfer-gate (21) is connected to a sub-block selector (22) and driver circuit (23).

6. The 3D CCD memory (10) of one of the claims 2 to 5, further comprising:
a plurality of bit lines (24), wherein each bit line (24) is associated with one or more CCD registers (16) in a block (14) and/or with one CCD register (16) in a sub-block (15); and
wherein the at least one input transfer-gate (21) associated with the sub-block (15) is operable to allow charge to be provided from a bit line (24) to the CCD register (16) associated with that bit line (24).

7. The 3D CCD memory (10) of claim 6, wherein the bit lines (24) associated with a block (14) are connected to respective input junctions (25).

8. The 3D CCD memory (10) of claim 7, wherein the bit lines (24) are further connected to a bit-line selector (26) and driver circuit (27), which is configured to insert charge via the bit lines (24) into the CCDs registers (16) of the sub-block (15), if the at least one input-transfer gate (21) associated with the sub-block (15) is operated.

9. The 3D CCD memory (10) of one of the claims 1 to 8, further comprising a plurality of word lines (28), wherein the CCD registers (16) in one block (14) are connected to the same set of word lines (28), and the word lines (28) are operable to allow charge to be transported along the CCD registers (16).

10. A method (30) of operating a 3D CCD memory (10) of one of the claims 1 to 9, wherein for writing information into a CCD register (16) of one sub-block (15) the method (30) comprises:
individually selecting (31) a block (14) and a sub-block (15) in the block (14);
and
inserting (32) charge into the CCD-registers (16) included in the selected sub-block (15).

11. The method (30) of claim 10, wherein:
selecting (31) the sub-block (15) comprises activating the at least one input-transfer gate (21), which is associated with the sub-block (15).

12. The method (30) of claim 11, wherein inserting (32) the charge into the CCD registers (16) comprises changing a voltage on the input junction (25), to which the bit lines (24) associated with the selected block (14) are connected.

13. The method (30) of one of the claims 10 to 12, wherein the charge is inserted (32) into the CCD registers (16) of each block (14) and is then moved simultaneously along the CCD registers (16) by operating clocking phases (41) associated with the charge storage capacitors in the CCD registers (16).

## Patentansprüche

1. Integrierter Speicher mit dreidimensionaler ladungsgekoppelter Vorrichtung, 3D-CCD-Speicher (10), der Folgendes umfasst:
einen Schichtstapel (11), der mehrere Gate-Schichten (11a) und Abstandhalterschichten (11b) enthält, die in einer ersten Richtung abwechselnd aufeinander angeordnet sind;
mehrere auf Halbleitern beruhende Kanäle (12), die sich im Stapel (11) erstrecken, wobei die Kanäle (12) in Kombination mit den Gate-Schichten (11a) und einer oder mehreren dielektrischen Schichten (13) mehrere Stränge von Ladungsspeicherkondensatoren bilden, die als mehrere CCD-Register (16) betreibbar sind, wobei jede der einen oder mehreren dielektrischen Schichten (13) zwischen einem der mehreren auf Halbleitern beruhenden Kanälen (12) und mindestens einer der mehreren Gate-Schichten (11a) angeordnet ist;
mehrere Blöcke (14), wobei jeder Block (14) mehrere Unterblöcke (15) umfasst und wobei jeder Unterblock (15) eine Gruppe der CCD-Register (16) umfasst;
wobei jeder Block (14) und jeder Unterblock (15) des Blocks (14) einzeln auswählbar sind, um Informationen in mindestens ein CCD-Register (16) des Unterblocks (15) des Blocks (14) zu schreiben.

2. 3D-CCD-Speicher (10) nach Anspruch 1, der ferner mehrere Eingangsübertragungs-Gates (21) umfasst, wobei jeder Unterblock (15) mindestens einem Eingangsübertragungs-Gate (21) zugeordnet ist und das mindestens eine Eingangsübertragungs-Gate (21) konfiguriert ist, den Unterblock (15) auszuwählen.

3. 3D-CCD-Speicher (10) nach Anspruch 2, wobei die mehreren Eingangsübertragungs-Gates (21) eine erste Gruppe Eingangsübertragungs-Gates (21), die den Unterblöcken (15) eines ersten Blocks (14) zugeordnet sind, und eine zweite Gruppe Eingangsübertragungs-Gates (21), die den Unterblöcken (15) eines zweiten Blocks (14) zugeordnet sind, umfassen.

4. 3D-CCD-Speicher (10) nach Anspruch 2 oder 3, wobei die Eingangsübertragungs-Gates (21) in den obersten einen oder mehreren Gate-Schichten (11a) des Schichtstapels (11) definiert sind und wobei die eine oder die mehreren obersten Gate-Schichten (11a) jeweils in mehrere Abschnitte geteilt sind, wobei jeder Abschnitt einem Unterblock (15) zugeordnet ist.

5. 3D-CCD-Speicher (10) nach einem der Ansprüche 2 bis 4, wobei jedes Eingangsübertragungs-Gate (21) mit einer Unterblock-Auswahleinheit (22) und einer Ansteuerschaltung (23) verbunden ist.

6. 3D-CCD-Speicher (10) nach einem der Ansprüche 2 bis 5, der ferner Folgendes umfasst:
mehrere Bit-Leitungen (24), wobei jede Bit-Leitung (24) einem oder mehreren CCD-Registern (16) in einem Block (14) und/oder einem CCD-Register (16) in einem Unterblock (15) zugeordnet ist; und
wobei das mindestens eine Eingangsübertragungs-Gate (21), das dem Unterblock (15) zugeordnet ist, betreibbar ist zu ermöglichen, dass Ladung von einer Bit-Leitung (24) dem CCD-Register (16) das dieser Bit-Leitung (24) zugeordnet ist, bereitgestellt wird.

7. 3D-CCD-Speicher (10) nach Anspruch 6, wobei die Bit-Leitungen (24), die einem Block (14) zugeordnet sind, mit jeweiligen Eingangsknotenpunkten (25) verbunden sind.

8. 3D-CCD-Speicher (10) nach Anspruch 7, wobei die Bit-Leitungen (24) ferner mit einer Bit-Leitungs-Auswahleinheit (26) und einer Ansteuerschaltung (27), die konfiguriert ist, Ladung über die Bit-Leitungen (24) in die CCD-Register (16) des Unterblocks (15) einzuspeisen, wenn das mindestens eine Eingangsübertragungs-Gate (21), das dem Unterblock (15) zugeordnet ist, betätigt wird, verbunden sind.

9. 3D-CCD-Speicher (10) nach einem der Ansprüche 1 bis 8, der ferner mehrere Wortleitungen (28) umfasst, wobei die CCD-Register (16) in einem Block (14) mit derselben Gruppe von Wortleitungen (28) verbunden sind und die Wortleitungen (28) betreibbar sind zu ermöglichen, dass Ladung entlang der CCD-Register (16) transportiert wird.

10. Verfahren (30) zum Betreiben eines 3D-CCD-Speichers (10) nach einem der Ansprüche 1 bis 9, wobei das Verfahren (30) zum Schreiben von Informationen in ein CCD-Register (16) eines Unterblocks (15) Folgendes umfasst:
einzeln Auswählen (31) eines Blocks (14) und eines Unterblocks (15) im Block (14); und
Einspeisen (32) von Ladung in das CCD-Register (16), das in dem ausgewählten Unterblock (15) enthalten ist.

11. Verfahren (30) nach Anspruch 10, wobei:
das Auswählen (31) des Unterblocks (15) das Aktivieren des mindestens einen Eingangsübertragungs-Gates (21), das dem Unterblock (15) zugeordnet ist, umfasst.

12. Verfahren (30) nach Anspruch 11, wobei das Einspeisen (32) der Ladung in die CCD-Register (16) das Ändern einer Spannung auf dem Eingangsknoten (25), mit dem die Bit-Leitungen (24), die dem ausgewählten Block (14) zugeordnet sind, verbunden sind, umfasst.

13. Verfahren (30) nach einem der Ansprüche 10 bis 12, wobei die Ladung in die CCD-Register (16) jedes Blocks (14) eingespeist (32) wird und anschließend gleichzeitig entlang der CCD-Register (16) bewegt wird, indem Taktphasen (41) betätigt werden, die den Ladungsspeicherkondensatoren in den CCD-Registern (16) zugeordnet sind.

## Revendications

1. Une mémoire intégrée (10) tridimensionnelle, 3D, à couplage de charge, CCD, comprenant :
un empilement de couches (11) comprenant une pluralité de couches de grille (11a) et de couches d'espacement (11b), disposées alternativement les unes sur les autres dans une première direction ;
une pluralité de canaux à base de semi-conducteurs (12) s'étendant dans l'empilement (11), les canaux (12) formant, en combinaison avec les couches de grille (11a) et une ou plusieurs couches diélectriques (13), une pluralité de chaînes de condensateurs de stockage de charge pouvant fonctionner comme une pluralité de registres CCD (16), chacune desdites une ou plusieurs couches diélectriques (13) étant disposée entre l'un de la pluralité de canaux à base de semi-conducteurs (12) et au moins l'une de la pluralité de couches de grille (11a) ;
une pluralité de blocs (14), où chaque bloc (14) comprend une pluralité de sous-blocs (15), et où chaque sous-bloc (15) comprend un ensemble des registres CCD (16) ;
chaque bloc (14) et chaque sous-bloc (15) du bloc (14) pouvant être sélectionnés individuellement, afin d'écrire des informations dans au moins un registre CCD (16) du sous-bloc (15) du bloc (14).

2. Mémoire 3D CCD (10) selon la revendication 1, comprenant en outre une pluralité de portes de transfert d'entrée (21), chaque sous-bloc (15) étant associé à au moins une porte de transfert d'entrée (21), et l'au moins une porte de transfert d'entrée (21) étant configurée pour sélectionner le sous-bloc (15).

3. Mémoire 3D CCD (10) selon la revendication 2, dans laquelle la pluralité de portes de transfert d'entrée (21) comprend un premier ensemble de portes de transfert d'entrée (21), qui sont associées aux sous-blocs (15) d'un premier bloc (14), et un second ensemble de portes de transfert d'entrée (21), qui sont associées aux sous-blocs (15) d'un second bloc (14).

4. Mémoire 3D CCD (10) selon la revendication 2 ou 3, dans laquelle les portes de transfert d'entrée (21) sont définies dans la ou les couches de grille supérieures (11a) de la pile de couches (11), et dans laquelle la ou les couches de grille supérieures (11a) sont respectivement séparées en une pluralité de parties, où chaque partie est associée à un sous-bloc (15).

5. Mémoire 3D CCD (10) selon l'une des revendications 2 à 4, dans laquelle chaque porte de transfert d'entrée (21) est connectée à un sélecteur de sous-bloc (22) et à un circuit d'attaque (23).

6. Mémoire 3D CCD (10) selon l'une des revendications 2 à 5, comprenant en outre :
une pluralité de lignes de bits (24), chaque ligne de bits (24) étant associée à un ou plusieurs registres CCD (16) dans un bloc (14) et/ou à un registre CCD (16) dans un sous-bloc (15) ; et
l'au moins une porte de transfert d'entrée (21) associée au sous-bloc (15) pouvant être actionnée de manière à permettre la fourniture d'une charge d'une ligne de bits (24) au registre CCD (16) associé à cette ligne de bits (24).

7. Mémoire 3D CCD (10) selon la revendication 6, dans laquelle les lignes de bits (24) associées à un bloc (14) sont connectées à des jonctions d'entrée respectives (25).

8. Mémoire 3D CCD (10) selon la revendication 7, dans laquelle les lignes de bit (24) sont en outre connectées à un sélecteur de ligne de bit (26) et un circuit d'attaque (27), qui est configuré pour insérer une charge via les lignes de bit (24) dans les registres CCD (16) du sous-bloc (15), si l'au moins une porte de transfert d'entrée (21) associée au sous-bloc (15) est actionnée.

9. Mémoire 3D CCD (10) selon l'une des revendications 1 à 8, comprenant en outre une pluralité de lignes de mots (28), dans laquelle les registres CCD (16) dans un bloc (14) sont connectés au même ensemble de lignes de mots (28), et les lignes de mots (28) peuvent être actionnées pour permettre le transport d'une charge le long des registres CCD (16).

10. Procédé (30) de fonctionnement d'une mémoire 3D CCD (10) selon l'une des revendications 1 à 9, dans lequel pour écrire des informations dans un registre CCD (16) d'un sous-bloc (15), le procédé (30) comprend :
la sélection individuelle (31) d'un bloc (14) et d'un sous-bloc (15) dans le bloc (14) ; et
l'insertion (32) d'une charge dans les registres CCD (16) inclus dans le sous-bloc sélectionné (15).

11. Procédé (30) selon la revendication 10, dans lequel :
la sélection (31) du sous-bloc (15) comprend l'activation de l'au moins une porte de transfert d'entrée (21), qui est associée au sous-bloc (15).

12. Procédé (30) selon la revendication 11, dans lequel l'insertion (32) de la charge dans les registres CCD (16) comprend la modification d'une tension sur la jonction d'entrée (25), à laquelle sont connectées les lignes de bits (24) associées au bloc sélectionné (14).

13. Procédé (30) selon l'une des revendications 10 à 12, dans lequel la charge est insérée (32) dans les registres CCD (16) de chaque bloc (14) et est ensuite déplacée simultanément le long des registres CCD (16) par actionnement des phases de cadencement (41) associées aux condensateurs de stockage de charge dans les registres CCD (16).
